# EUROPÄISCHE PATENTSCHRIFT

(11) **EP 0 852 810 B1**
(45) Veröffentlichungstag und Bekanntmachung des Hinweises auf die Patenterteilung: **09.10.2002**
(21) Anmeldenummer: 97935422.2
(22) Anmeldetag: 14.07.1997
(51) Int. Cl.: H01L 23/495

(54) **HALBLEITERBAUELEMENT MIT ISOLIERENDEM GEHÄUSE**
SEMICONDUCTOR COMPONENT WITH INSULATING HOUSING
COMPOSANT A SEMI-CONDUCTEUR A BOITIER ISOLANT

(30) Priorität: 23.07.1996 DE 19629768
(43) Veröffentlichungstag der Anmeldung: 15.07.1998
(73) Patentinhaber: Infineon Technologies AG, 81669 München (DE)
(72) Erfinder: GRAF, Alfons, D-86916 Kaufering (DE)
(74) Vertreter: Patentanwälte Westphal, Mussgnug & Partner
(86) Internationale Anmeldenummer: DE9701483
(87) Internationale Veröffentlichungsnummer: WO98003998

(56) Entgegenhaltungen:
- GOODENOUGH F: "P-DMOSFET AND TSSOP TURNS ON WITH 2.7 VGS" 2.Mai 1994 , ELECTRONIC DESIGN, VOL. 42, NR. 9, PAGE(S) 89/90, 92, 94/95 XP000450752 siehe das ganze Dokument
- ZOLLO S: "THE BOOM STARTS IN SMART POWER PRODUCTS" 24.Juli 1986 , ELECTRONICS DE 1984 A 1985: ELECTRONICS WEEK, VOL. 59, NR. 27, PAGE(S) 97 - 101 XP000051602 siehe Seite 97 - Seite 98; Abbildungen 1,2
- STORTI S ET AL: "A 30A 30V DMOS MOTOR CONTROLLER AND DRIVER" 17.Februar 1988 , IEEE INTERNATIONAL SOLID STATE CIRCUITS CONFERENCE, VOL. 31, PAGE(S) 192/193, 365/366 XP000112815 siehe Seite 192; Abbildungen 2,7
- LEMME H: "KRAFT UND INTELLIGENZ VEREINT" 26.Mai 1989 , ELEKTRONIK, VOL. 38, NR. 11, PAGE(S) 80 - 83 XP000120849 siehe das ganze Dokument
- ALFONS GRAF: "SMART SIPMOS POWER SWITCHES IN STANDARD SMD PACKAGES" Dezember 1995 , SIEMENS COMPONENTS, VOL. 30, NR. 6, SEITEN 31 - 34 XP002046960 siehe das ganze Dokument

## Beschreibung

Die Erfindung bezieht sich auf ein Halbleiterbauelement mit
a) einem isolierenden Gehäuse,
b) einer im Gehäuse angeordneten metallenen unteren Montageplatte,
c) einem Halbleiterkörper mit zumindest einem Logikteil und zumindest einem Leistungsteil mit vertikalen MOS-Transistoren, wobei
d) der Halbleiterkörper mit seiner Unterseite elektrisch leitend auf der Montageplatte befestigt ist,
e) metallenen unteren Anschlußleitern, die elektrisch mit dem Halbleiterkörper verbunden sind und von denen zumindest einer elektrisch mit der Montageplatte verbunden ist.

Halbleiterbauelemente mit solchen Gehäusen sind bekannt. Solche Gehäuseformen sind z. B. das DIL-Gehäuse (Dual-In-Line) oder P-DSO-Gehäuse (Plastic-Dual-Small-Outline). Die erstgenannten Gehäuse sind für normale Montage und die zuletzt genannten Gehäuse sind für die sogenannte Oberflächen-Montage (SMD) auf gedruckten Leiterplatten vorgesehen. Diese Gehäuse enthalten eine metallene Montageplatte sowie metallene Anschlußleiter, die mit der Montageplatte bzw. den auf der Montageplatte befestigten Bauelementen elektrisch verbunden sind. Die Montageplatte und die Anschlußleiter werden aus einem Leiterrahmen (Leadframe) ausgeschnitten.

Die Halbleiterkörper werden dann über die sogenannte Bond-Draht-Technik mit den Anschlußleitern verbunden (siehe z.B F. Goodenough,"P-DMOSFET and TSSOP Turns On With 2.7 V_{GS}", Electronic Design, Vol.42, No 9 (2 May 1994), S.89-95).

Bei Halbleiterkörpern, die aus einem Logikteil und einem Leistungsteil mit vertikalen MOS-Transistoren bestehen (siehe z-B. H.Lemme, "Kraft und Intelligenz vereint", Elektronik, Vol. 38, No. 11, 26. Mai 1989, S.80-83), hat sich gezeigt, daß durch die allgemein bekannte Bond-Draht-Technik der Verwirklichung von sehr niederohmigen Leistungsschaltern Grenzen gesetzt sind. Bei der Verwendung von beispielsweise acht parallel geschalteten Bond-Drähten mit 50 µm Durchmesser ergibt sich ein additiver Durchlaßwiderstand von ca. 5 mΩ. Bei einem Leistungsschalter von beispielsweise 25 mΩ gesamten Durchlaßwiderstand wird zur Kompensation des durch die parallel geschalteten Bond-Drähte verursachten Widerstandes ein Mehraufwand von ca. 4 qmm Silizium im Halbleiterkörper verursacht.

Im übrigen sind Mehrfachbondungen im allgemeinen unerwünscht und stellen ein Qualitätsproblem dar.

Der Erfindung liegt daher die Aufgabe zugrunde, ein Halbleiterbauelement der eingangs genannten Art derart weiterzubilden, daß ein Mehraufwand an Silizium unnötig ist und besonders niederohmige Leistungsschalter realisiert werden können.

Erfindungsgemäß wird diese Aufgabe mit einem Halbleiterbauelement gelöst, welches dadurch gekennzeichnet ist, daß das Gehäuse eine der Zahl der Leistungsteile entsprechende Zahl von oberen Montageplatten aufweist, die elektrisch leitend auf den Oberseiten der Leistungsteile des Halbleiterkörpers befestigt sind und elektrisch mit Anschlußleitern verbunden sind.

Durch diese Konzeption wird bei Leistungsteilen mit vertikalen MOS-Transistoren ein sehr niederohmiger Hauptstrompfad von der unteren Montageplatte und den unteren Anschlußleitern zur oberen Montageplatte und den oberen Anschlußleitern erreicht.

Ein weiterer Vorteil liegt darin, daß die obere Montageplatte sehr nahe an der aktiven Halbleiterschicht der vertikalen MOS-Transistoren anliegt. Dadurch bildet die obere Montageplatte eine sehr gute thermische Speicherkapazität für den Leistungsschalter. Dies ist insbesondere in der Anwendung des Halbleiterbauelementes bei kurzzeitiger Verlustleistungsaufnahme von Vorteil.

In einer bevorzugten Ausführungsform sind die von den oberen Anschlußleitern überdeckten unteren Anschlußleiter ausgespart und die oberen und unteren Anschlußleiter liegen in einer gemeinsamen Ebene. Dadurch wird der Halbleiterkörper sandwichartig gepackt und es ergeben sich keine Probleme bei der Einbringung in das Gehäuse.

Typischerweise ist das Gehäuse quaderförmig und die Anschlußleiter ragen an den Längsseiten aus dem Gehäuse.

Die Erfindung wird anhand eines Ausführungsbeispieles in Verbindung mit den Figuren näher erläutert. Es zeigen
- Figur 1: eine Aufsicht auf das Leitersystem des Halbleiterbauelementes und
- Figur 2: einen Schnitt entlang der Linie I - I aus Figur 1.

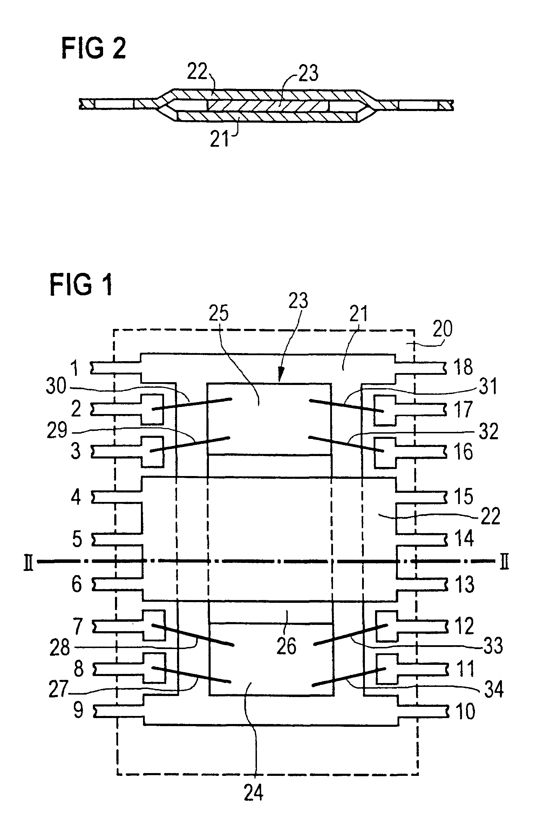

Das Halbleiterbauelement nach Figur 1 ist in einem vollisolierenden Gehäuse 20 aus Plastik untergebracht. Der Außenumfang des Gehäuses 20 ist schematisch durch gestrichelte Linien dargestellt. Das Gehäuse ist hier z. B. vom Typ P-DSO-18 mit achtzehn Anschlußleitern, die mit Bezugszeichen 1 bis 18 versehen sind. Das Gehäuse 20 enthält eine untere Montageplatte 21, die mit den Anschlußleitern 1,9,10 und 18 verbunden ist. Auf dieser unteren Montageplatte 21 ist der Halbleiterkörper 23 angeordnet. Der Halbleiterkörper 23 ist auf die untere Montageplatte 21 z. B. durch Auflöten oder durch einen leitfähigen Klebstoff fixiert und dadurch elektrisch und thermisch leitend mit der unteren Montageplatte 21 verbunden.

Der Halbleiterkörper 23 besteht aus zwei Logikteilen 24, 25 und einem Leistungsteil 26. Der Leistungsteil 26 stellt einen Halbleiterschalter dar, der aus vertikalen MOS-Transistoren aufgebaut ist. Auf die Oberfläche des Leistungsteiles 26 ist eine obere Montageplatte 22 angeordnet. Diese obere Montageplatte 22 ist ebenfalls durch Auflöten oder durch einen leitfähigen Kleber fixiert und dadurch mit der aktiven Halbleiterschicht des Leistungsteiles 26 elektrisch und thermisch leitend verbunden.

Die obere Montageplatte 22 ist mit Anschlußleitern 4 - 6 und 13 - 15 versehen. Die von den oberen Anschlußleitern 4 - 6 und 13 - 15 überdeckten unteren Anschlußleiter sind auf der unteren Montageplatte 21 ausgespart, d. h., die obere Montageplatte 22 bildet mit den oberen Anschlußleitern 4 - 6 und 13 - 15 die in der unteren Montageplatte 21 fehlenden Anschlußleiter.

Die Logikteile 24, 25 sind auf ihrer, von der unteren Montageplatte 21 abgewandten Seite durch Bond-Drähte 27 - 34 mit den Anschlußleitern 2, 3, 7, 8, 11, 12, 16 und 17 verbunden, die keine elektrische Verbindung zu der unteren Montageplatte 21 haben.

Wie aus der Figur 2 zu ersehen ist, liegen die oberen Anschlußleiter 4 - 6 und 13 - 15 und die unteren Anschlußleiter 1 - 3, 7 - 8, 10 - 12 und 16 - 18 in einer gemeinsamen Ebene. Letztendlich ragen die Anschlußleiter 1 - 18 an den Längsseiten in einer gemeinsamen Ebene aus dem Gehäuse (nicht gezeigt).

Das beschriebene Verfahren läßt sich auch für die Anschlüsse des Logikteils erweitern.
So können Stege in der oberen Montageplatte auch die Verbindungen zu den Pads 2-3, 7-8, 11-12, 16-17 herstellen.
Die untere Montageplatte kontaktiert dann nur noch den Drain-Anschluß des Leistungstransistors.

### Bezugszeichenliste

- 1 - 3, 7 - 8, 10 - 12, 16 - 18 =: untere Anschlußleiter
- 4 - 6, 13 - 15 =: obere Anschlußleiter
- 20 =: Gehäuse
- 21 =: untere Montageplatte
- 22 =: obere Montageplatte
- 23 =: Halbleiterkörper
- 24 =: Logikteil
- 25 =: Logikteil
- 26 =: Leistungsteil
- 27 - 34 =: Bond-Drähte

## Patentansprüche

1. Halbleiterbauelement mit
a) einem isolierenden Gehäuse (20),
b) einer im Gehäuse (20) angeordneten metallenen unteren Montageplatte (21),
c) einem Halbleiterkörper (23) mit zumindest einem Logikteil (24, 25) und zumindest einem Leistungsteil (26) mit vertikalen MOS-Transistoren, wobei
d) der Halbleiterkörper (23) mit seiner Unterseite elektrisch leitend auf der unteren Montageplatte (21) befestigt ist, und
e) metallenen unteren Anschlußleitern (1 - 3, 7 - 8, 10 - 12, 16 - 18), von denen zumindest einer (1, 9, 10, 18) elektrisch mit der unteren Montageplatte verbunden ist, und von denen die übrigen elektrisch mit dem Halbleiterkörper (23) verbunden sind.
**dadurch gekennzeichnet,**
**daß**
f) das Gehäuse (20) einer der Zahl der Leistungsteile (26) entsprechende Zahl von oberen Montageplatten (22) aufweist, die elektrisch leitend auf den Oberseiten der Leistungsteile (26) des Halbleiterkörpers (23) befestigt sind und elektrisch mit oberen Anschlußleitern (4 - 6, 13 - 15) verbunden sind.

2. Halbleiterbauelement nach Anspruch 1,
**dadurch gekennzeichnet,**
**daß** die Projektionen der oberen Anschlußleiter (4 - 6, 13 - 15) und der unteren Anschlußleiter (1 - 3, 7 - 8, 10 - 12, 16 - 18) auf die Ebene der unteren Montageplatte (21) nicht überlappend sind.

3. Halbleiterbauelement nach Anspruch 2,
**dadurch gekennzeichnet,**
**daß** die oberen Anschlußleiter (4 - 6, 13 - 15) und die unteren Anschlußleiter (1 - 3, 7 - 8, 10 - 12, 16 - 18) in einer gemeinsamen Ebene liegen.

4. Halbleiterbauelement nach Anspruch 3,
**dadurch gekennzeichnet,**
**daß** das Gehäuse (20) quaderförmig ist.

## Claims

1. A semiconductor component having
a) an insulating housing (20),
b) a metal lower mounting plate (21) disposed in the housing (20),
c) a semiconductor body (23) having at least one logic part (24, 25) and at least one power part (26) with vertical MOS transistors, wherein
d) the semiconductor body (23) is attached by its underside to the lower mounting plate (21) in an electrically conductive manner, and
e) metal lower leads (1 - 3, 7 - 8, 10 - 12, 16 - 18), at least one of which (1, 9, 10, 18) is electrically connected to the lower mounting plate, and the remaining ones of which are electrically connected to the semiconductor body (23),
**characterised in that**
f) the housing (20) comprises a number of upper mounting plates (22) corresponding to the number of power parts (26), which plates are attached in an electrically conductive manner to the upper sides of the power parts (26) of the semiconductor body (23) and are connected electrically to upper leads (4 - 6, 13 - 15).

2. A semiconductor component according to Claim 1,
**characterised in that** the projections of the upper leads (4 - 6, 13 - 15) and of the lower leads (1 - 3, 7 - 8, 10 - 12, 16 - 18) do not overlap on the plane of the lower mounting plate (21).

3. A semiconductor component according to Claim 2,
**characterised in that** the upper leads (4 - 6, 13 - 15) and the lower leads (1 - 3, 7 - 8, 10 - 12, 16 - 18) lie in a common plane.

4. A semiconductor component according to Claim 3,
**characterised in that** the housing (20) is cuboidal.

## Revendications

1. Composant semi-conducteur comprenant :
a) un boîtier isolant (20),
b) une plaque de montage (21) inférieure, métallique prévue dans le boîtier (20),
c) un composant semi-conducteur (23) avec au moins une partie logique (24, 25) et au moins une partie de puissance (26) formée de transistors MOS verticaux,
d) le composant semi-conducteur (23) étant fixé par sa face inférieure, en conduction électrique sur la plaque de montage inférieure (21) et
e) des conducteurs de branchement métalliques inférieurs (1-3, 7-8, 10-12, 16-18) dont au moins un (1, 9, 10, 18) est relié électriquement à la plaque de montage inférieure, et dont les autres sont reliés électriquement au corps semi-conducteur (23),
**caractérisé en ce que**
f) le boîtier (20) comporte un nombre de plaques de montage supérieures (22) correspondant au nombre de parties de puissance (26), ces plaques de montage étant fixées en conduction électrique sur le côté supérieur de la partie de puissance (26) du composant semi-conducteur (23) en étant reliées électriquement aux conducteurs de branchement supérieurs (4-6, 13-15).

2. Composant semi-conducteur selon la revendication 1,
**caractérisé en ce que**
les projections des conducteurs de branchements supérieurs (4-6, 13-15) et des conducteurs de branchement inférieurs (1-3, 7-8, 10-12, 16-18) sur le plan de la plaque de montage inférieure (21) ne se chevauchent pas.

3. Composant semi-conducteur selon la revendication 2,
**caractérisé en ce que**
les conducteurs de branchement supérieurs (4-6, 13-15) et les conducteurs de branchement inférieurs (1-3, 7-8, 10-12, 16-18) sont situés dans un plan commun.

4. Composant semi-conducteur selon la revendication 3,
**caractérisé en ce que**
le boîtier (20) est de forme rectangulaire.
